# EUROPEAN PATENT APPLICATION

(11) **EP 3 293 284 A1**
(43) Date of publication of application: **14.03.2018**
(21) Application number: 17196167.5
(22) Date of filing: 25.02.2014
(51) Int. Cl.: C23C 14/34, B22F 3/14, B22F 3/15, C22C 1/04, C22C 9/00, C22F 1/08, C22C 28/00, C22F 1/00, C22F 1/16

(54) **SPUTTERING TARGET AND METHOD OF PRODUCING THE SAME**

(30) Priority: 25.02.2013 JP 2013034389; 17.01.2014 JP 2014006532
(62) Divisional of application: 14754195.7
(71) Applicant: MITSUBISHI MATERIALS CORPORATION, Chiyoda-ku Tokyo 100-8117 (JP)
(72) Inventor: Zhang, Shoubin, Hyogo, 6691339 (JP); Umemoto, Keita, Hyogo, 6691339 (JP)
(74) Representative: Hoffmann Eitle

(57) **Abstract**

A sputtering target, which has excellent mechanical workability; and makes it possible to deposit a film of a compound including Cu and Ga as major components, is provided.

The sputtering target includes: with respect to all of the metal elements in the sputtering target, 15.0 to 50.0 atomic% of Ga; 0.1 to 10.0 total atomic% of one or more metal elements selected from Al, Zn, Sn, Ag, and Mg; and the Cu balance and inevitable impurities.

In the sputtering target, the theoretical density is 95% or more, and the oxygen content is 800 weight ppm or less.

## Description

### FIELD OF THE INVENTION

The present invention relates to a sputtering target used in forming a film of a compound including Cu and Ga as major components, and a method of producing the film.

Priority is claimed on Japanese Patent Application No. 2013-034389, filed February 25, 2013, and Japanese Patent Application No. 2014-006532, filed January 17, 2014, the contents of which are incorporated herein by reference.

### BACKGROUND OF THE INVENTION

Conventionally, the Cu-Ga sputtering target is the essential material for producing a solar cell with the Cu-In-Ga-Se quaternary alloy film (CIGS film) as its light-absorbing layer by the so-called "selenization (Se) method." The selenization method is a method of forming a film of a quaternary Cu-In-Ga-Se compound, for example, by: sputtering a Cu-Ga alloy film having thickness of about 500nm; laminating an In film at thickness of 500nm by sputtering on the film; and heating the films in H₂Se gas at 500°C to diffuse Se to the Cu-Ga alloy film and the In film (for example, refer Patent Literatures 1 and 2 (PTLs 1 and 2)).

On the other hand, in order to improve efficiency of electric power generation of the light-absorbing layer made of Cu-In-Ga-Se quaternary alloy film, sodium (Na) addition to the light-absorbing layer is proposed (for example, refer PTL 2 and Non Patent Literature 1 (NPL 1)). In this proposal, it is disclosed that the Na content in the precursor film (Cu-In-Ga-Se quaternary alloy film) is generally set to about 0.1%.

### [Related Art Documents]

### [Patent Literature]

PTL 1: Japanese Patent (Granted) Publication No. 3249408 (B)
PTL 2: Japanese Unexamined Patent Application, First Publication No. 2009-283569 (A)

### [Non Patent Literature]

NPL 1: A. Romeo, "Development of Thin-film Cu(In,Ga)Se2 and CdTe Solar Cells", Prog. Photovolt: Res. Appl. 2004; 12:93-111 (DOI: 10.1002/pip.527)

### [Problems to be Solved by the Present Invention]

The above-described related arts, there are problems to be solved explained below.

Surface machining during sputtering target production from the Cu-Ga alloy material is difficult since the Cu-Ga alloy material having high density and high Ga content has very high hardness and poor ductility. Thus, there is no other choice but to perform grinding work. Because of this, machining speed of the sputtering target becomes slow. In addition, it is difficult to machine the sputtering target into a complex shape in the grinding work. Furthermore, similar problems exist in the case where Na is added to the Cu-Ga alloy material.

The present invention is made under the circumstances described above. The purpose of the present invention is to provide: a sputtering target, which has excellent mechanical workability and makes it possible to deposit a film of a compound including Cu and Ga as major components; and a method of producing the above-described sputtering target.

### SUMMARY OF THE INVENTION

### [Means to Solving the Problems]

The inventors of the present invention conducted extensive studies in order to produce a sputtering target for depositing a film of a compound containing Cu and Ga as major components. As a result, they found that mechanical workability of the Cu-Ga alloy material can be improved by adding a small amount of one or more metal elements selected from the group consisting of: Al; Zn; Sn; Ag; and Mg to the Cu-Ga alloy.

The present invention is made based on the above-explained finding and has aspects described below to solve the problems.
(1) An aspect of the present invention is a sputtering target including: with respect to all of the metal elements in the sputtering target, 15.0 to 50.0 atomic% of Ga; 0.1 to 10.0 total atomic% of one or more metal elements selected from Al, Zn, Sn, Ag, and Mg; and the Cu balance and inevitable impurities.
(2) In the sputtering target described in the above-described (1), a theoretical density ratio is 95% or more, and an oxygen content may be 800 weight ppm or less.
(3) In the sputtering target described in the above-described (1) or (2), a bending strength may be 200 MPa or more.
(4) In the sputtering target described in any one of the above-described (1) to (3), an average grain size of a metallic phase including one or more metal elements selected from Al, Zn, Sn, Ag, and Mg, may be 500 µm or less.
(5) The sputtering target described in any one of the above-described (1) to (4) may further include, with respect to all of the metal elements in the sputtering target, 0.01 to 10.0 total atomic% of one or more elements selected from Li, K, and Na.
(6) Another aspect of the present invention is a production method of the sputtering target according to any one of the above-described (1) to (4), the method including the step of producing an ingot by melting Cu and Ga; and one or more metal elements selected from Al, Zn, Sn, Ag, and Mg at 1050°C or higher to obtain a melted material, and by casting the melted material.
(7) Another aspect of the present invention is a production method of the sputtering target according to any one of the above-described (1) to (4), the method including the steps of: preparing a raw material powder including: Cu; Ga; and one or more metal elements selected from Al, Zn, Sn, Ag, and Mg, each of which are included as an elemental powder or an alloy powder including two or more of Cu, Ga, Al, Zn, Sn, Ag, and Mg; and sintering the raw material powder in a vacuum; in an inert atmosphere; or in a reduction atmosphere.
(8) Another aspect of the present invention is a production method of the sputtering target according to the above-described (5), the method including the steps of: preparing a raw material powder by mixing: a metal powder including: Cu; Ga; and one or more metal elements selected from Al, Zn, Sn, Ag, and Mg, each of which are included as an elemental powder or an alloy powder including two or more of Cu, Ga, Al, Zn, Sn, Ag, and Mg; and NaF powder, Na₂S powder, or Na₂Se powder; and sintering the raw material powder in a vacuum; in an inert atmosphere; or in a reduction atmosphere.
(9) In the production method the sputtering target according to the above-described (7) or (8), the average grain size of the raw material powder may be 1 to 500 µm.

As described above, the sputtering target of an aspect of the present invention includes: with respect to all of the metal elements in the sputtering target, 15.0 to 50.0 atomic% of Ga; 0.1 to 10.0 total atomic% of one or more metal elements selected from Al, Zn, Sn, Ag, and Mg; and the Cu balance and inevitable impurities. Since the sputtering target of the present invention includes 0.1 to 10.0 total atomic% of one or more metal elements selected from Al, Zn, Sn, Ag, and Mg, the sputtering target of the present invention can have high machinability by cutting.

The reason for setting the additive amount of the one or more metal elements selected from Al, Zn, Sn, Ag, and Mg (hereinafter, referred as the Al and other additive elements) within the range of 0.1 to 10 atomic% is as follows. If the additive amount were less than 0.1 atomic%, improvement of the mechanical workability could not be obtained. If the additive amount exceeded 10 atomic%, the sputtering target itself would embrittle, cracking or fracturing during cutting work being prone to occur. As the Al and other additive elements, any single element, which means only a single kind of the elements in other words, may be added. Alternatively, 2 kinds or more of the additive elements may be added at the same time as long as the total atomic% of them is in the range of 0.1 to 10 atomic%. In this case, the sputtering target made of the Cu-Ga alloy, which is the mother alloy, can have high machinability by cutting. The reason for setting the Ga content in the range of 0.1 to 10 atomic% is that the Ga content within this range is a common Ga additive amount for forming a CIGS light-absorbing layer with a high conversion rate. "Metal elements" in this specification mean elements excluding nonmetallic elements. The nonmetallic elements are H, He, C, N, O, F, Ne, P, S, CI, Ar, Se, Br, Kr, 1, Xe, At, and Rn.

In addition, in the sputtering target related to an aspect of the present invention, the theoretical density ratio is set to 95% or more, and the oxygen content is set to 800 weight ppm or less. In the sputtering target, the Al and other additive element(s) is(are) added to the Cu-Ga alloy. The additive elements such as Al or the like are much more prone to be oxidized compared to Cu and Ga. Thus, in the case where the oxygen content in the target material exceeds 800 weight ppm, many inclusions such as Al oxides, Zn oxides, Sn oxides, Mg oxides, and the like, are formed. These inclusions of oxides weaken the bonding between grains of Cu-Ga alloy in the target matrix. Accordingly, defects are formed on the cutting surface during high-speed cutting in machining work of the target material to deteriorate flatness of the cut surface and to increase occurrence of defects.

Another feature of the sputtering target related to the above-described aspect of the present invention is that the theoretical density ratio is set to 95% or more. The theoretical density ratio means the density of the substantial part of an ingot without a pore in the case where the ingot is produced by: casting in a carbon mold after melting the Cu-Ga alloy, which has the identical composition and includes the Al and other additive element(s), in a vacuum melting furnace at 1100°C or higher; and slowly cooling at the cooling rate of 50°C/min or slower. In the case where the target material is produced by the dissolution casting method, the density of the ingot could be reduced depending on the choice of the casting method and/or the casting process. In addition, in the case where the target material is produced by the sintering method, the theoretical density ratio of the obtained target material could be 95% or less depending on the sintering condition or the like. The purpose of the present invention is to provide: the sputtering target, which has excellent mechanical workability and makes it possible to deposit the film of the compound including Cu and Ga as major components; and the method of producing the sputtering target. To accomplish the purpose, in regard to the target material, to which the Al and other additive element(s) is(are) added, used in the sputtering target of the aspect of the present invention, the theoretical density ratio is set to 95% or more. By having the configuration, formation of defects at a low density part of the target material during cutting can be reduced to the minimum level and more excellent cutting-machinability can be obtained. Moreover, by setting the theoretical density ratio of the target material to 95% or more, holes passing through to the outer air are significantly reduced in the target material. Thus, the contact opportunity of the Al and other additive elements, which is more prone to be oxidized than the conventionally included Cu and Ga in the target material, to oxygen can be reduced; and formation of oxide inclusions originated from the Al and other additive element(s) can be significantly reduced. By reducing these oxide inclusions, during the high-speed cutting of the target material, defect formation on the cut surface is prevented; and the flatness of the cut surface is improved.

In addition, in the sputtering target related to an aspect of the present invention, the bending strength of the sputtering target is set to 200 MPa or more.

The inventors of the present invention found that the machinability by cutting of the sputtering target can be improved when the bending strength is set to 200 MPa or more in the sputtering target made of Cu and Ga to which the Al and other additive element(s) is(are) added. In other words, if it were the sputtering target related to an aspect of the present invention with the bending strength of 200 MPa or more, it would be easier to obtain a target surface with a higher flatness during machine work of the target material.

In addition, in the sputtering target related to an aspect of the present invention, the average grain size of a metallic phase including the Al and other additive element(s) (hereinafter, referred as the Al and other additive-containing phase) is set to 500 µm or less.

The Al and other additive-containing phase is softer and has a lower melting point than the metal phase made of Cu and Ga. By distributing the Al and other additive-containing phase in a relatively small size in the target, effective lubrication between the cutting tool and the surface of the target material can be obtained during cutting work. When the average grain size of the Al and other additive-containing phase exceeds 500µm, difference of cutting-machinability between: the metal phase made of Cu and Ga with a relatively high melting point and high hardness; and the Al and other additive-containing phase with a relatively low melting point and low hardness is exacerbated in the texture of the target material during cutting, and the surface roughness of the target is problematically increased, compare to the target material that includes an equivalent amount of Al and other additive element(s); an equivalent oxygen content; and the average grain size of 500µm or less. The average grain size of the Al and other additive-containing phase is defined as the average of diameters of corresponding circles of the projected area of the Al and other additive-containing grains.

In addition, in the sputtering target related to an aspect of the present invention, the sputtering target further includes, with respect to all of the metal elements in the sputtering target, 0.01 to 10.0 total atomic% of one or more elements selected from Li, K, and Na.

By adding one or more of Li, K, and Na, the electric power generation efficiency of the solar cell can be improved. When the content amount of the additive element is less than 0.01 atomic%, the effect obtained by the addition cannot be obtained. When it exceeds 10.0 atomic%, it is not preferable since peeling of the CuGa film occurs frequently in the high temperature selenization process.

In the case where Na is added to the above-described sputtering target related to an aspect of the present invention, if Na is added in the form of: NaF; Na₂S; Na₂Se; Na₂SeO₃; or Na₂SeO₄, Na in the target is prone to be evenly distributed. In addition, the Cu-Ga alloy film containing Na, which is effective for improving electric power generation efficiency, can be deposited. The presence of fluoride (F) and sulfur (S) in the Cu-Ga alloy film including Na is kept at a level low enough not to influence to the characteristics of the light-absorbing layer of the solar cell. In order to reduce the oxygen content amount in the target, adding in the form of NaF, Na₂S, or Na₂Se is more preferable than adding in the form of Na₂SeO₃ or Na₂SeO₄. Similarly, in the case that K or Li is added, it is preferable to add in the form of a compound such as: potassium fluoride (KF); potassium sulfide (K₂S); potassium selenide (K₂Se); potassium nitride (K₃N); potassium chloride (KCl); potassium selenate; lithium fluoride (LiF); lithium sulfide (Li₂S); lithium selenide (Li₂Se); lithium nitride (Li₃N); lithium chloride (LiCI); lithium selenate; and the like.

Moreover, the cutting-machinability of the target can be improved by adding antimony (Sb) or bismuth (Bi) in the sputtering target of an aspect of the present invention. Preferably, the content amount of these additive elements is 0.01 to 10.0 atomic%.

The production method of the sputtering target related to another aspect of the present invention includes the step of producing an ingot by melting Cu and Ga; and one or more metal elements selected from Al, Zn, Sn, Ag, and Mg at 1050°C or higher to obtain a melted material, and by casting the melted material.

The Al and other additive element(s) in the texture of the ingot can be evenly distributed with certainty by melting the material at 1050°C or higher in the production method of the sputtering target. In addition, the oxygen content amount of the sputtering target can be reduced by producing it by casting.

The production method of the sputtering target related to another aspect of the present invention includes the steps of: preparing a raw material powder including: Cu; Ga; and one or more metal elements selected from Al, Zn, Sn, Ag, and Mg, each of which are included as an elemental powder or an alloy powder including two or more of Cu, Ga, Al, Zn, Sn, Ag, and Mg; and sintering the raw material powder in a vacuum; in an inert atmosphere; or in a reduction atmosphere.

The production method of the sputtering target related to another aspect of the present invention includes the steps of: preparing a raw material powder by mixing: a metal powder including: Cu; Ga; and one or more metal elements selected from Al, Zn, Sn, Ag, and Mg, each of which are included as an elemental powder or an alloy powder including two or more of Cu, Ga, Al, Zn, Sn, Ag, and Mg; and NaF powder, Na₂S powder, or Na₂Se powder; and sintering the raw material powder in a vacuum; in an inert atmosphere; or in a reduction atmosphere.

In addition, in the production method of the sputtering target related to another aspect of the present invention, the average grain size of the raw material powder is set to 1 to 500 µm.

By setting the average grain size of the raw material powder to 1 to 500 µm, the size of the Al and other additive-containing phase in the obtained target material can be limited to 500 µm or less with certainty; and cutting-machinability of the target material can be improved even more in these production methods of the sputtering target. Moreover, by setting the average grain size of the raw material powder to 1 µm or more, increase of the oxygen content amount in the target material due to excessive miniaturization of the raw material powder can be prevented, and the oxygen content amount in the target can be controlled to 800 weight ppm or less without difficulty.

### [Effects of the Invention]

According to the present invention, the technical effects described below can be obtained.

According to the Cu-Ga binary alloy sputtering target and the production method of the target related to the present invention, high cutting-machinability of the sputtering target can be obtained, since the target has 0.1 to 10.0 total atomic% of one or more metal elements selected from Al, Zn, Sn, Ag, and Mg. Therefore, the surface machining in cutting during machining work is easy in the sputtering target of an aspect of the present invention. In addition, machining speed of the sputtering target becomes fast, and machining of a target with a complex shape becomes easy.

### BRIEF DESCRIPTION OF THE DRAWINGS

FIG. 1 is a photographic image showing the surface of a target after machining work in a sputtering target related to Example of the present invention.
FIG. 2 is a photographic image showing the surface of a target after machining work in a sputtering target related to Comparative Example.
FIG. 3 is photographic images showing: a composition image (COMPO image); a Cu element distribution image; a Ga element distribution image; and Sn element distribution image of the sputtering target shown in FIG. 1. The images are obtained by the electron micro analyzer (EPMA).
FIG. 4 is a graph showing the result of X-ray diffraction (XRD) of the sputtering target shown in FIG. 1.

### DETAILED DESCRIPTION OF THE INVENTION

Embodiments of the sputtering target and the production method of the sputtering target, which are related to aspects of the present invention, are explained below.

The sputtering target of the present embodiment has a component composition made of: with respect to all of the metal elements in the sputtering target, 15.0 to 50.0 atomic% of Ga; 0.1 to 10.0 total atomic% of one or more metal elements selected from Al, Zn, Sn, Ag, and Mg (Al and other additive elements); and the Cu balance and inevitable impurities.

In addition, in some of the sputtering targets of the present embodiment, the theoretical density ratio is 95% or more, and the oxygen content is 800 weight ppm or less. Furthermore, in some of the sputtering targets of the present embodiment, the bending strength is 200 MPa or more.

In addition, it is preferable that the average grain size of the metallic phase including the Al and other additive element(s) (Al and other additive-containing phase) is 500 µm or less. This Al and other additive-containing phase includes; the elemental substance made of the Al and other additive element(s); the metal phase made of an alloy or an intermetallic compound of the Al and other additive elements; and the metal phase made of an alloy or the intermetallic compound of the Al and other additive elements, Cu, and Ga.

Generally, the grain size of the metal phase is set to several millimeters to 10 mm plus several millimeters (about 2 mm to about 19 mm) in the Cu-Ga target material produced by the dissolution casting method. In addition, it is general that the grain size of the metal phase becomes several hundred micrometers to several thousand micrometers in the powder sintering method, depending on the used production method or the size of raw material powders; and the sintering condition. By including the Al and other additive -containing phase in the metal structure, cutting-machinability is improved to some extent, even if the grain size of the Al and other additive-containing phase is set to the same level in the conventional dissolution casting method or the powder sintering method for example. However, according to the studies related to the present invention, by setting the average grain size of the Al and other additive-containing phase in the structure of the target material to 500 µm or less, damages to the surface of the target material during cutting-machining are reduced, and even more flatter machined surface is obtained. In order to obtain a casted target material that has the metal structure having the Al and other additive-containing phase with the average grain size of 500 µm or less, a process such as the quench casting and the hot rolling after casting is needed to be done appropriately. In the powder sintering method, the average grain size of the raw material powder in the used raw material has to be limited to 500 µm or less, and the sintering temperature or the like has to be optimized in order to obtain the target material with the above-explained specific average grain size.

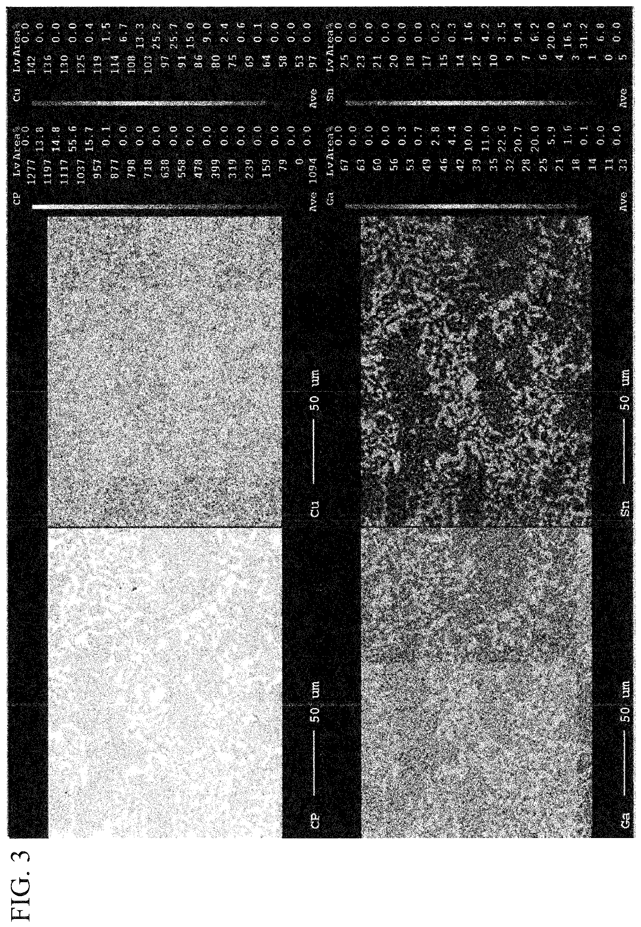

The Al and other additive-containing phase can be observed, for example in the element mapping images (FIG. 3) related to Cu, Ga, and Al and other additive element(s) by the electron micro analyzer (EPMA) within the range of 10 mm×10 mm, and the grain size (diameter of corresponding circles of the projected area) can be measured accordingly.

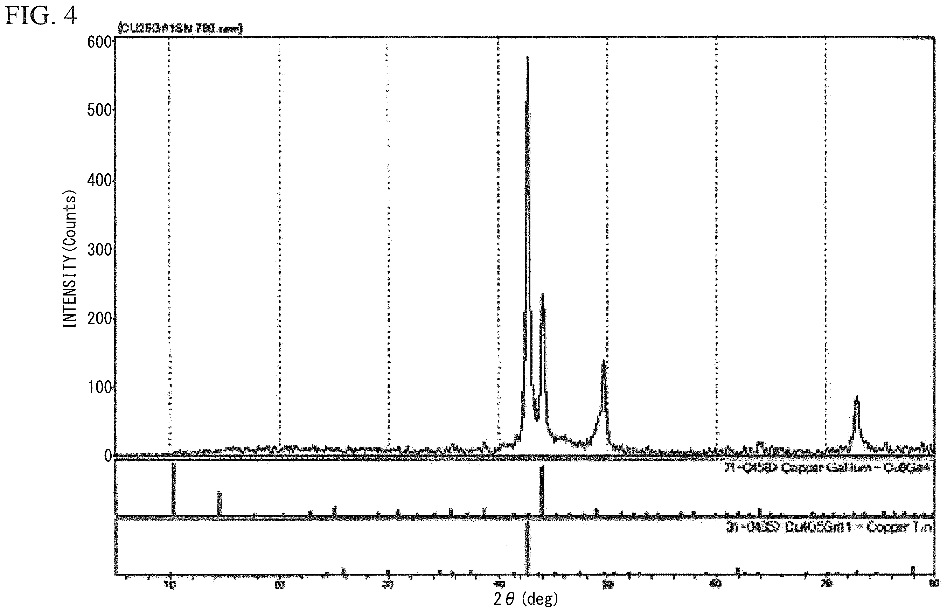

In addition, it is preferable that Ga in the target is included in the form of an intermetallic compound, for example in the form of Cu-Ga intermetallic compound, in the sputtering target of the present embodiment. When the elemental substance of Ga exists in the target, the bending strength of the target is reduced to 200 MPa or less. In that case, Ga precipitates as a liquid phase by the processing heat during machining and machining defects are prone to occur. In other words, the cutting-machinability of the sputtering target is improved by avoiding the presence of the elemental substance of Ga in the sputtering target. The presence or absence of the elemental substance of Ga; and the presence or absence of Cu-Ga alloy can be determined by X-ray diffraction (XRD) measurement of the sputtering target, for example (FIG. 4).

More specifically, XRD measurement is performed after grinding the surface of these sputtering targets (Ra: 5 µm or less). Then, the presence or absence of the elemental substance of Ga can be determined based on the peaks in the vicinity of θ=15.24° (orientation 111), in the vicinity of θ=22.77° (113), and in the vicinity of θ=23.27° (202). The presence or absence of Cu-Ga alloy can be determined based on the standard diffraction curve card by performing XRD measurement in the same way.

Sodium may be included as NaF compound, Na₂S compound, or Na₂Se compound to the sputtering target of the present embodiment.

In terms of composition evaluation of each of the above-described metal elements, the sputtering targets are crashed and subjected to a quantitative analysis of their content amounts using ICP method (Inductively Coupled Plasma Method).

In addition, Li, K, Na, and compounds thereof, which are effective for improvement of electrical conversion rate of the solar cell and improvement of cutting-machinability of the target material, can be included in the sputtering target of the present embodiment. It is preferable that the content amounts of Li, K, and Na is in the range of 0.01 to 10 atomic% as the total amount of them. Furthermore, similar effects can be obtained by adding Sb and Bi. The preferable content amount of Sb and Bi is in the range of 0.01 to 10 atomic% as the total amount of them.

The dissolution casting method and the powder method can be used for producing the sputtering target of the present embodiment. In terms of the powder method, there are the methods in which the raw material powder is sintered after molding if necessary or without molding (hereinafter, referred as "the powder sintering method"); the method in which the raw material powder in a semi-molten state is sprayed on a substrate at high speed and the obtained compact is directly used as a target material; and the method in which the obtained compact is subjected to sintering further to be the target material.

The sputtering target is produced by the dissolution casting method by performing the processes explained below. First, an ingot with the oxygen content amount of 800 weight ppm or less is produced by melting: at least elementary substances of each of Cu, Ga, and Al and other additive elements; or the alloy containing 2 or more of the above-mentioned elements, at 1050°C or higher. Then, the obtained ingot is subjected to a quench casting or a rolling as needed in order to optimize the crystal structure of the obtained ingot.

The melting point of Cu-Ga-based alloy containing 15 atomic% or more of Ga, and 0.1 atomic% or more of the Al and other additive element(s) is(are) 1000°C or less. The reason for setting the melting temperature at 1050°C or higher is that if it were lower than 1050°C, the viscosity of the melt including Cu, Ga, and the Al and other additive element(s) would be kept at high level, making it difficult for each of the melted elements to be evenly mixed. In other words, miniaturization of the Al and other additive-containing phase in the obtained ingot would be difficult. In that case, occurrence of cracking or fracturing during machining of the target material would be increased. Therefore, the melting temperature is set to 1050°C or higher.

In addition, if the oxygen content amount in the target material exceeded 800 weight ppm, the oxide inclusions would be easily formed by introduction of the Al and other additive element(s). In this case, the presence of the oxide inclusions weakens the bonding between the grains of Cu-Ga alloy. As a result, occurrence of defects on the cut surface is increased during high speed cutting of the target material.

In terms of the dissolution casting method, there is no specific limitation for measures to keep the oxygen content amount in the target material to 800 weight ppm or less. For example, the dissolution casting method using a vacuum melting furnace; the dissolution casing method in an atmosphere free of oxygen; the dissolution casting method using a carbon crucible or a carbon mold having deoxidizing effect in the air; the dissolution casting method in which the surface of the melt is covered by a deoxidizing material such as carbon particles in the air; the method in which alkaline metal such as lithium metal, sodium metal, or potassium metal is added to the melt for deoxidization; or the like can be used.

The powder sintering method includes a process of preparing the raw material powder, which includes at least Cu, Ga, and each of the Al and other additive elements as an elemental powder; or alloy powder including two or more of Cu, Ga, and each of the Al and other additive element(s); and a process of sintering the raw material powder in a vacuum; in an inert atmosphere; or in a reduction atmosphere, by hot pressing (HP) or hot isostatic pressing (HIP). As an alternative sintering process, a sintering process, in which the prepared raw material powder after press-molding is sintered in a vacuum; in an inert atmosphere with an atmospheric pressure of 0.01-10kgf/cm²; or in a reduction atmosphere in a non-pressurized state, can be used. It is preferable that the average grain size of the raw material powder is 1-500 µm.

In the sintering by using HP method or HIP method, it is preferable that the sintering is performed at HP temperature (the holding temperature in HP) and HIP temperature (the holding temperature in HIP) set in the range of 150-900°C. The reason for setting the temperature range is that if it were lower than 150°C, chipping would be likely to occur during cutting work due to a lowered density of the sintered material; and if it exceeded 900°C, it would cause working defects due to increased average grain size of the Cu-Ga alloy including the Al and other additive elements during hot pressing.

In the sintering using the method in which the compact is sintered in a vacuum; in an inert gas atmosphere; or in a reduction atmosphere after press-molding the raw material powder, it is preferable that the sintering is performed at the sintering temperature (the holding temperature in sintering) set in the range of 150-950°C. The reason for setting the temperature range is that if it were lower than 150°C, chipping would be likely to occur during cutting work due to a lowered density of the sintered material; and if it exceeded 950°C, it would cause working defects due to increased average grain size of the Cu-Ga alloy including the Al and other additive elements.

Preparation of the raw material powder for performing the above-explained sintering is performed by any one of the processes (a)-(c) described below, for example.
(a) The raw material powder is obtained by melting the total amount of the predetermined amounts of Cu, Ga, and the Al and other additive elements; and by crushing the ingot made of Cu, Ga and the Al and other additive elements. The above-described dissolution casting is performed in a vacuum; in an inert gas atmosphere; or in the air. Alternatively, the raw material powder is obtained by preparing an atomized powder of the total amount of the predetermined amounts of Cu, Ga, and the Al and other additive elements. In the case where Na, K, or Li is added, metallic Na, K, or Li is added during casting; or a predetermined amount of a powder of a compound of Na, K, or Li, such as NaF, KF, LiF, Na₂S, K₂S, Li₂S, Na₂Se, K₂Se, Li₂Se, or the like, is added to the above-described raw material powder.
(b) The Cu-Ga raw material powder is obtained by crushing the Cu-Ga ingot made of the total amount of the predetermined amount of Cu and Ga. Alternatively, a predetermined amount of the Cu-Ga alloy is prepared as an atomized powder. Then, by mixing the powder of the Al and other additive elements to the Cu-Ga raw material powder, the raw material powder having a predetermined composition is prepared. In the case where Na, K, or Li is added, metallic Na, K, or Li is added during casting; or a predetermined amount of a powder of a compound of Na, K, or Li, such as NaF, KF, LiF, Na₂S, K₂S, Li₂S, Na₂Se, K₂Se, Li₂Se, or the like, is added to the above-described raw material powder. A powder made of an elemental powder selected from the Al and other additive elements; or an alloy powder made of 2 or more elements selected from the Al and other additive elements, is included in the powder of the above-described Al and other additive elements.
(c) The Cu-Ga alloy raw material powder including the additive element is obtained by: melting a part of the total amount of the predetermined amounts of Cu, Ga, and the Al and other additive elements; and crushing the ingot made of Cu, Ga, and the Al and other additive element(s). Alternatively, the raw material powder of the Cu-Ga alloy including the Al and other additive element(s) is prepared from a part of the total amount of the predetermined amounts of Cu, Ga, and the Al-additive element as an atomized powder. Then, by mixing the Cu-Ga alloy powder; the Cu powder; or the powder made of the alloy of the Al and other additive element(s) and Cu or Ga, to the above-described raw material powder of the Cu-Ga alloy including the Al and other additive element(s), the mixed powder having a predetermined composition is prepared. In the case where Na, K, or Li is added, metallic Na, K, or Li is added during casting; or a predetermined amount of a powder of a compound of Na, K, or Li, such as NaF, KF, LiF, Na₂S, K₂S, Li₂S, Na₂Se, K₂Se, Li₂Se, or the like, is added to the above-described raw material powder.

Next, the raw material powder prepared by any one of the above-described processes (a)-(c) is subjected to HP (hot pressing) or HIP (hot isostatic pressing); or the raw material powder is press-molded. Then, the compact is sintered by sintering or the like. During this sintering process, in order to prevent the Cu-Ga alloy or Cu from being oxidized, it is preferable to perform the sintering in vacuum; in an inert gas atmosphere; or a reduction atmosphere. Pressure in HP and HIP has a substantial impact on density of the sputtering target sintered material. Thus, a preferable pressure for HP is 100-1000kgf/cm². A preferable pressure for HIP is 500-1500kgf/cm². Pressure may be applied before the beginning of temperature rising during sintering. Alternatively, pressure may be applied after reaching to a given temperature.

Next, the sputtering target is manufactured by shaping the target material into a predetermined shape by using the cutting method since the Cu-Ga target material including the Al and other additive element(s) (or the Cu-Ga target material including the Al and other additive element(s) and Na, Li, or K) obtained by the above-described dissolution casting method or the sintering method has an excellent mechanical workability. Then, the sputtering target manufactured as explained above is bonded to a backing place made of Cu or Cu alloy by using In, followed by application to sputtering process.

In order to prevent the processed sputtering target from being oxidized or taking moisture, it is preferable that the sputtering target to be stored after vacuum packing the whole body of the sputtering target or packing it in a bag with an inert gas replacement.

Sputtering using this sputtering target of the present embodiment is performed by the direct current (DC) magnetron sputtering method in Ar gas. In this direct current sputtering, a pulse superposition power supply that applies pulse voltage may be used. Alternatively, a DC power supply with no pulse may be used.

The sputtering target of the present embodiment includes the Al and other additive elements and its total amount is 0.1-10 atomic%. Thus, even if the sputtering target has a high density ratio, it has high cutting-machinability. Particularly, oxide inclusions of the Al and other additive elements are reduced by setting the theoretical density ratio of the sputtering target to 95% or higher and at the same time adjusting the oxygen content to 800 weight ppm or less. Accordingly, the cutting-machinability can be further improved.

In addition, by setting the bending strength to 200 MPa or more in the sputtering target, a machined surface suitable for sputtering can be obtained without occurrence of chipping and fracturing during cutting work. Effective implementations in order to obtain the bending strength to 200 MPa or more in the sputtering target are: reduction of casting defects and miniaturization of the metal structure in the production method using the dissolution casting method; and reduction of sintering defects, an appropriate sintering density, and miniaturization of the sintered structure by the sintering condition such as the sintering temperature in the production method using the sintering method. In addition, the bending strength of 200 MPa or more can be obtained by promoting alloying or even distribution of the additive elements having a low bending strength as an elementary substance in the target, regardless of the dissolution casting method and the sintering method.

Furthermore, setting the average gran size of the phase containing the Al and other additive element(s) in the sputtering target to 500 µm or less has an impact on the machinability by cutting of the sputtering target. Accordingly, if that condition is satisfied, occurrence of chipping, fracturing, or the like are further reduced during mechanical working.

In addition, the Cu-Ga film including Na, Li, or K, which is effective on improvement of electrical power generation efficiency can be deposited by the sputtering method using the sputtering target including L, K, or Na as: LIF compound; KF compound; NaF compound; Li₂S compound; K₂S compound; Na₂S compound; or a compound of Li₂Se, K₂Se, Na₂Se, Li₂SeO₃, K₂SeO₃, Na₂SeO₃, Li₂SeO₄, K₂SeO₄, Na₂SeO₄, or the like. The contents of fluoride (F) and sulfur (S) in the Cu-Ga film including Li, K, or Na will not be high enough to the extent particularly influencing on the characteristics of the light-absorbing layer of the solar cell.

### [Example]

Next, the sputtering target and the method of producing the sputtering target related to the present invention are explained by Examples actually produced based on the above-described embodiments in regard to the evaluation results in reference to Tables 1 to 6 below.

### [Preparation of raw material powder or ingot]

Table 1 shows component compositions (at%) of the raw material powders in Examples 1-30 (Ex. 1-30) of the present invention based on the present embodiments. Table 2 shows component compositions (at%) of the raw material powders in Comparative Examples 1-20 (C. Ex. 1-20) for comparison to Examples of the present invention.

First, as raw material powders for Examples 2, 3, 5-8, 10, 12, 13, 19-26, 29, and 30 of the present invention; and Comparative Examples 1-6, 10, 12, 14-18, Cu, Ga, and each of specified metal elements were inserted into an atomizing apparatus in order to obtain the compositions shown in Tables 1 and 2. Then, temperature was raised to 1050-1150°C. After confirming that all the metals were turned into melt, atomization was performed. Then, obtained powders were passed through a sieve having an opening diameter of 250 µm, and the atomized powders were prepared.

In Example 10 of the present invention, the above-described atomized powder was subjected to dry-ball-milling in an Ar atmosphere to adjust the average diameter of the powder to 0.9 µm. In Example 19 of the present invention, each of the Cu-50at%Ga alloy and the Al-Zn alloy was atomized. Then, the pure Cu powder having the average grain size of 2 µm and purity of 99.99% (hereinafter referred as the pure Cu powder); and the NAF powder having the average grain size of 3 µm and purity of 99% (hereinafter referred as the NAF powder) were added to the atomized powder. Then the raw material powder with the composition shown in Table 1 was mixed in a dry-ball mill.

In Example 5 of the present invention, the raw material powder was mixed by dry-ball milling the atomized powder obtained from the Cu-50at%Ga ingot; the same pure Cu powder used in Example 19 of the present invention; and the pure Zn powder having the average grain size of 3 µm and purity of 99.99% (hereinafter referred as the pure Zn powder).

In Example 12 of the present invention, the raw material powder was prepared by mixing the Cu-Ga atomized powder with each of powders of the additive element Al, and Bi. The average grain size of the used pure Al powder was 125 µm. In terms of the pure Bi powder, the average grain size was 308 µm and purity was 99.9%.

In Example 20 of the present invention, the raw material powder was prepared by atomizing Cu, Ga, and Sn; and adding the NAF powder by ball-milling.

In Example 21 of the present invention, the raw material powder was prepared by adding the pure Zn powder; and the NaF powder to the Cu-Ga atomized powder, and mixing the obtained material by mixing by dry-ball milling.

In Example 22 of the present invention, the raw material powder shown in Table 1 was prepared by dry-mixing the Cu-Ga atomized powder; the Al-Sn powder having purity of 99.99% and the average grain size of 234 µm; and the NAF powder.

In Example 24 of the present invention, the raw material powder was obtained by mixing the Cu-Ga atomized powder; the Al-Zn powder having purity of 99.99% and the average grain size of 158 µm; the Sb powder having purity of 99.99% and the average grain size of 260 µm; and the Na₂S powder having purity of 99% and the average grain size of 9 µm (hereinafter referred as the Na₂S powder).

In Example 26 of the present invention, the raw material powder was obtained by mixing the Cu-Ga atomized powder; the pure Al powder; the pure Zn powder; the pure Sn powder having the average grain size of 2 µm and purity of 99.9% (hereinafter referred as the pure Sn powder); and the Na₂Se powder having the average grain size of 10 µm and purity of 98%, by using a rocking mixer.

In Example 29 of the present invention, the raw material powder was prepared by adding the pure Zn powder and the KF powder to the Cu-Ga atomized powder and mixing the obtained material by a dry-ball mill.

In Example 30 of the present invention, the raw material powder was prepared by adding the pure Zn powder, the pure Mg powder, and the NAF powder to the Cu-Ga atomized powder and mixing the obtained material by a dry-ball mill.

In Comparative Example 5, the raw material powder was prepared by mixing the Cu-Ga atomized powder and the Sn powder evenly by using a V-type mixer.

In Comparative Example 16, the raw material powder was prepared by atomizing each element of Cu, Ga, Al, Zn, Sn and Sb; and mixing the obtained atomized powder and the Na₂S powder by a ball mill.

In Comparative Example 18, the raw material powder was prepared by mixing the atomized powder from Cu, Ga, Zn, and Bi; and the Na₂Se powder.

In Examples 1, 9, 27, and 28 of the present invention; and Comparative Examples 7-9, 11, 19, and 20, each of additive elements was inserted into the vacuum melting furnace in order to obtain the compositions shown in Tables 1 and 2. Then, after confirming that it reached to a specified melting temperature and all the metals were melted, it was held for 10 minutes for performing casting. Melting and casting may be performed in a vacuum. Alternatively, they may be performed in an inert gas atmosphere. In the case in the inert gas atmosphere, it is preferable that the pressure of the atmosphere is lower than the atmospheric pressure.

In Examples 1, 27 and 28 of the present invention, a water-cooled mold was used for obtaining a small metal cast structure. In Example 9 of the present invention and Comparative Examples 7-9, 11, 19, and 20, the water-cooled mold was not used, and the materials were left in the vacuum melting furnace after casting in a graphite mold, and natural cooling was performed. Although, in Examples 4 and 11 of the present invention, the vacuum casting was performed as explained above, the obtained ingot was further subjected to dry-crushing in an inert gas atmosphere to be the material for powder sintering.

Examples 11, 14, and 15-18; and Comparative Example 13, air casting was performed. In the air casting, the total amount of the component in the compositions shown in Table 1 was inserted into an air casting furnace. Then, after it reached to a specified melting casting temperature, it was held for 10 minutes. Then, the material in the furnace was poured into a graphite mold, and subjected to natural cooling. In Examples 11 and 14 of the present invention, the obtained ingot was subjected to dry-crushing to be the material for powder sintering.

### [Production of the sputtering target and evaluation]

In the above-described Examples 1, 9, 15-18, 27 and 28 of the present invention; and Comparative Examples 7-9, 11, 13, 19 and 20, hot rolling was performed to the casted ingots. The rolling temperature was 800°C and annealing was performed at 750°C for 1 hour. Rolling reduction in Examples 1, 15-18, 27 and 28 of the present invention was 50%, and in Example 9 of the present invention, it was 10%.

In the above-described Examples 7, and 13 of the present invention; and Comparative Example 2, metal molds were filled with the raw material powders. After performing molding at the pressure of 1000kgf/cm², sintering was performed in a pure hydrogen atmosphere with the air pressure of 0.3-1.2.

In Examples 2-8, 10-14, 19-26, 29 and 30 of the present invention; and Comparative Examples 1, 3-6, 10, 12, and 14-18, the target materials were produced by using pressurized sintering methods (HP, HIP). The pressurized sintering was performed in a graphite mold filled with the raw material powder at the pressure and temperature specified in Tables 3 and 4. In Comparative Examples 6 and 17, sintering was performed in an iron mold filled with the raw material powder. Both of the rates of temperature increase and decrease in hot pressing were 1-12°C/min.

By using the materials obtained as explained above, the sputtering targets having diameter of 80mm and thickness of 6mm were produced. The dimension density of the obtained sputtering target was calculated. The results as the calculated theoretical density ratios are shown in Tables 3 and 4.

In the calculation of the theoretical density ratio, the theoretical density ratio was obtained by: melting the metal phase of Cu, Ga, the Al and other additive element(s), Bi, Sb, Li, or the like in the sputtering target; defining the density of the defect-free ingot obtained by slow cooling as the theoretical density in the specific composition; and obtaining the theoretical density ratio from the ratio of the sputtering target to the above-mentioned theoretical density (target density/theoretical density × 100%). In the case where NaF, Na₂S, or Na₂Se was added, the volume ratio was calculated by using the added amount of the compound phase. Then, the theoretical densities of the metal phase and the Na compound in the sintered material were calculated; and the theoretical density ratio was calculated from the ratio of the dimension density of the target to the sum of them.

As evaluations of workability and effect of cutting of the sputtering target, the presence or absence of cracking during working; the presence or absence of fracturing (visual defect of 2mm or larger introduced by working); the presence or absence of chipping (visual defect smaller than 2mm introduced by working); and the surface roughness (Ra: average arithmetic roughness, Rz: ten-point average roughness) were measured and evaluated individually. The results are shown in Tables 5 and 6.

The content amount of each of metal elements in the sputtering target was analyzed using an analytical block collected from the target by ICP method. The oxygen content was analyzed using the analytical block by the carbon dioxide absorption method.

The bending strength of the sputtering target was obtained by measuring the three-point bending strength of the target material based Japanese industrial standard, JIS R1601.

Observation of the structure of the sputtering target was performed by surface distribution (mapping) measurement of each of elements by EPMA (electron probe micro analyzer, model JXA-8500F, manufactured by JEOL Ltd.) after embedding a piece of the sintered sputtering target in a resin; and wet-polishing to obtain a flat surface. The observation was performed in the condition where: the accelerating voltage was 15kV; the irradiation current was 50nA; the scanning type was one-way; the pixels (X, Y) were 240 and 180, respectively; the spot size (X, Y) were 0.1 µm and 0.1 µm, respectively; and the measurement time was 10 ms. In addition, the observation magnification was set to 100-fold, and an area of 10×5mm was subjected to the element distribution (mapping) measurements multiple times separately. Then, the average grain size of the structure with at least the elemental substance of the Al and other additive element(s) or the intermetallic compound of the Al and other additive element(s) was confirmed based on the obtained mapping image. The results explained above are shown in Tables 5 and 6.

In the evaluation methods of the workability and the effect of cutting, first, the target materials of Examples of the present invention and Comparative Examples were subjected to dry-cutting by using the lathe model MS850G manufactured by DMG Mori Seiki Co., Ltd.. The size was: 80 mm of diameter; and 6 mm of thickness. The rate of rotation was 140 rpm. The depth of cut was 0.3 mm, and the feeding rate was 0.097mm/rev by the cutting tool. The shape model number of the tool bit was STFER1616H16 (manufactured by Mitsubishi Materials Co., Ltd.). The shape model number of the insert was TEGX160302L and the kind of the material was HTi10. The evaluation of the surface of the sintered material was done after cutting from the surface of each material in the thickness of 1.0 mm. The measurement of the surface roughness, and confirmation of the present or absence of fracturing and chipping on the surface due to cutting, were performed in the location 20mm away from the center part of the machined sintered material. As a measurement apparatus of the surface roughness, the surftest model SV-3000 manufactured by Mitutoyo Co., Ltd. was used. The measurement length was 4 mm. In judging the presence or absence of chipping, a photograph of the range of 22cm² was taken by a low magnification optical microscope. Then, the presence or absence of chipping was judged based on the presence or absence of chipping corresponding to an inscribed circle with diameter of 0.3 mm or more.

**[Table 1]**

| | Ga (at%) | Al (at%) | Zn (at%) | Sn (at%) | Ag (at%) | Mg (at%) | Bi (at%) | Sb (at%) | Li (at%) | K (KF addition) (at%) | Na (NaF addition) (at%) | Na (Na₂S addition) (at%) | Na (Na₂Se addition) (at%) | Cu (at%) | Ave. grain size (µm) |
|---|---|---|---|---|---|---|---|---|---|---|---|---|---|---|---|
| Ex. 1 | 15.0 | 0.15 | - | - | - | - | - | - | - | - | - | - | - | balance | - |
| Ex. 2 | 40.0 | 5.00 | - | - | - | - | - | - | - | - | - | - | - | balance | 23.00 |
| Ex. 3 | 20.0 | - | 0.30 | - | - | - | - | - | - | - | - | - | - | balance | 79.00 |
| Ex. 4 | 35.0 | - | 9.00 | - | - | - | - | - | - | - | - | - | - | balance | 479.00 |
| Ex. 5 | 35.0 | - | 8.00 | - | - | - | - | - | - | - | - | - | - | balance | 67.00 |
| Ex. 6 | 30.0 | - | 2.00 | - | - | - | - | - | - | - | - | - | - | balance | 0.80 |
| Ex. 7 | 30.0 | - | - | 3.00 | - | - | - | - | - | - | - | - | - | balance | 68.00 |
| Ex. 8 | 30.0 | - | - | 3.00 | - | - | - | - | - | - | - | - | - | balance | 32.00 |
| Ex. 9 | 30.0 | - | 3.00 | 3.00 | - | - | - | - | - | - | - | - | - | balance | - |
| Ex. 10 | 40.0 | 6.00 | 2.00 | 1.00 | - | - | - | - | - | - | - | - | - | balance | 0.90 |
| Ex. 11 | 35.0 | 3.00 | 3.00 | 3.00 | - | - | - | - | - | - | - | - | - | balance | 367.00 |
| Ex. 12 | 45.0 | 3.00 | - | - | - | - | 2.00 | - | - | - | - | - | - | balance | 3.00 |
| Ex. 13 | 35.0 | 2.00 | - | - | - | - | - | 1.00 | - | - | - | - | - | balance | 30.00 |
| Ex. 14 | 35.0 | - | - | 9.00 | - | - | - | - | 1.00 | - | - | - | - | balance | 453.00 |
| Ex. 15 | 25.0 | - | - | 3.00 | - | - | - | - | 2.00 | - | - | - | - | balance | - |
| Ex. 16 | 25.0 | - | 3.00 | - | - | - | - | - | 1.00 | - | - | - | - | balance | - |
| Ex. 17 | 25.0 | 1.00 | - | - | - | - | - | - | 0.20 | - | - | - | - | balance | - |
| Ex. 18 | 25.0 | 1.00 | - | - | - | - | - | - | 0.10 | - | - | - | - | balance | - |
| Ex. 19 | 25.0 | 0.50 | 0.50 | - | - | - | - | - | - | - | - | - | - | balance | 81.00 |
| Ex. 20 | 20.0 | - | - | 0.30 | - | - | - | - | - | - | - | - | - | balance | 121.00 |
| Ex. 21 | 30.0 | - | 3.00 | - | - | - | - | - | - | - | - | - | - | balance | 43.00 |
| Ex. 22 | 35.0 | 2.00 | - | 2.00 | - | - | - | - | - | - | - | - | - | balance | 52.00 |
| Ex. 23 | 30.0 | 5.00 | - | - | - | - | - | - | - | - | - | 9.00 | - | balance | 201.00 |
| Ex. 24 | 35.0 | 2.00 | 2.00 | - | - | - | - | 1.00 | - | - | - | 0.50 | - | balance | 49.00 |
| Ex. 25 | 30.0 | 10.00 | - | - | - | - | - | - | - | - | - | - | 1.00 | balance | 107.00 |
| Ex. 26 | 50.0 | 2.00 | 3.00 | 3.00 | - | - | - | - | - | - | - | - | 0.50 | balance | 205.00 |
| Ex. 27 | 30.0 | - | - | - | 5.00 | - | - | - | - | - | - | - | - | balance | - |
| Ex. 28 | 30.0 | - | - | - | - | 5.00 | - | - | - | - | - | - | - | balance | - |
| Ex. 29 | 30.0 | - | 3.00 | - | - | - | - | - | - | 1.00 | - | - | - | balance | 32.00 |
| Ex. 30 | 30.0 | - | 0.50 | - | - | 0.50 | - | - | - | - | 0.50 | - | - | balance | 36.00 |

**[Table 2]**

| | Ga (at%) | Al (at%) | Zn (at%) | Sn (at%) | Ag (at%) | Mg (at%) | Bi (at%) | Sb (at%) | Li (at%) | K (KF addition) (at%) | Na (NaF addition) (at%) | Na (Na₂S addition) (at%) | Na (Na₂Se addition) (at%) | Cu (at%) | Ave. grain size (µm) |
|---|---|---|---|---|---|---|---|---|---|---|---|---|---|---|---|
| C. Ex. 1 | 28.0 | - | - | - | - | - | - | - | - | - | - | - | - | balance | 75.00 |
| C. Ex. 2 | 40.0 | - | - | - | - | - | - | - | - | - | - | - | - | balance | 66.00 |
| C. Ex. 3 | 35.0 | 0.05 | - | - | - | - | - | - | - | - | - | - | - | balance | 89.00 |
| C. Ex.4 | 29.0 | - | - | 0.08 | - | - | - | - | - | - | - | - | - | balance | 88.00 |
| C. Ex. 5 | 30.0 | - | - | 0.08 | - | - | - | - | - | - | - | - | - | balance | 25.00 |
| C. Ex. 6 | 35.0 | - | - | 15.00 | - | - | - | - | - | - | - | - | - | balance | 71.00 |
| C. Ex. 7 | 35.0 | 0.03 | - | - | - | - | 0.07 | - | - | - | - | - | - | balance | - |
| C. Ex. 8 | 35.0 | - | 11.00 | - | - | - | 7.00 | - | - | - | - | - | - | balance | - |
| C. Ex. 9 | 30.0 | 12.00 | - | - | - | - | - | 0.05 | - | - | - | - | - | balance | - |
| C. Ex. 10 | 30.0 | - | 20.00 | - | - | - | - | - | 0.30 | - | - | - | - | balance | 68.00 |
| C. Ex. 11 | 20.0 | - | - | 20.00 | - | - | 6.50 | - | 0.50 | - | - | - | - | balance | - |
| C.Ex. 12 | 30.0 | - | - | - | - | - | - | - | - | - | - | - | - | balance | 77.00 |
| C. Ex. 13 | 30.0 | - | - | - | - | - | - | - | 1.0 | - | - | - | - | balance | - |
| C. Ex. 14 | 30.0 | - | 0.08 | - | - | - | - | - | - | - | - | - | - | balance | 84.00 |
| C. Ex. 15 | 25.0 | 15.00 | - | - | - | - | - | - | - | - | - | 0.50 | - | balance | 91.00 |
| C. Ex. 16 | 35.0 | 0.02 | 0.02 | 0.02 | - | - | - | 1.00 | - | - | - | 2.00 | - | balance | 13.00 |
| C. Ex. 17 | 45.0 | 5.00 | 5.00 | 5.00 | - | - | 0.50 | - | - | - | - | - | 1.00 | balance | 121.00 |
| C. Ex. 18 | 38.0 | - | 0.07 | - | - | - | 0.06 | - | - | - | - | - | 1.00 | balance | 29.00 |
| C. Ex. 19 | 30.0 | - | - | - | - | - | 20.00 | - | - | - | - | - | - | balance | - |
| C. Ex. 20 | 30.0 | - | - | - | 18.00 | - | - | - | - | - | - | - | - | balance | - |

**[Table 3]**

| | Matrix manufacturing method | Press molding sintering method Pressing pressure (kgf/cm²) | HP, HIP methods Pressure during sintering (kgf/cm²) | Dissolution casting Melting Temperature (°C) | Sintering temperature (°C) | Presence or absence of rolling in casting | Sintering time in sintering (H) | Theoretical density ratio (%) |
|---|---|---|---|---|---|---|---|---|
| Ex. 1 | Casting into a water-cooled mold in casting | | | 1100 | | Present | | 100 |
| Ex. 2 | HP | | 200 | | 320 | | 2 | 95 |
| Ex. 3 | HIP | | 850 | | 800 | | 0.75 | 98 |
| Ex. 4 | HP | | 400 | | 450 | | 2 | 96 |
| Ex. 5 | HIP | | 1500 | | 360 | | 1 | 99 |
| Ex. 6 | HP | | 300 | | 700 | | 1 | 98 |
| Ex. 7 | Press molding, pressureless sintering in hydrogen | 1200 | | | 700 | | 2 | 97 |
| Ex. 8 | HP | | 150 | | 650 | | 3 | 90 |
| Ex. 9 | Air-cooling without use of water-cooling mold in casting | | | 1100 | | Present | | 100 |
| Ex. 10 | HP | | 150 | | 330 | | 5 | 90 |
| Ex. 11 | HP | | 350 | | 380 | | 2 | 96 |
| Ex. 12 | HIP | | 1000 | | 200 | | 1 | 99 |
| Ex. 13 | Press molding, pressureless sintering in hydrogen | 1500 | | | 600 | | 3 | 93 |
| Ex. 14 | HP | | 400 | | 450 | | 2 | 97 |
| Ex. 15 | Air-cooling without use of water-cooling mold in casting | | | 1100 | | Present | | 100 |
| Ex. 16 | Air-cooling without use of water-cooling mold in casting | | | 1100 | | Present | | 100 |
| Ex. 17 | Air-cooling without use of water-cooling mold in casting | | | 1150 | | Present | | 100 |
| Ex. 18 | Air-cooling without use of water-cooling mold in casting | | | 1100 | | Absent | | 100 |
| Ex. 19 | HP | | 300 | | 750 | | 2 | 98 |
| Ex. 20 | HIP | | 1200 | | 750 | | 2 | 98 |
| Ex. 21 | HP | | 200 | | 700 | | 2 | 96 |
| Ex. 22 | HP | | 250 | | 360 | | 3 | 97 |
| Ex. 23 | HIP | | 1200 | | 550 | | 1 | 98 |
| Ex. 24 | HIP | | 1000 | | 500 | | 2 | 98 |
| Ex. 25 | HP | | 300 | | 640 | | 2 | 97 |
| Ex. 26 | HP | | 300 | | 150 | | 3 | 95 |
| Ex. 27 | Casting into a water-cooled mold in casting | | | 1100 | | Present | | 100 |
| Ex. 28 | Casting into a water-cooled mold in casting | | | 1100 | | Present | | 100 |
| Ex. 29 | HP | | 300 | | 750 | | 1 | 98 |
| Ex. 30 | HP | | 300 | | 750 | | 2 | 98 |

**[Table 4]**

| | Matrix manufacturing method | Press molding sintering method Pressing pressure (kgf/cm²) | HP, HIP methods Pressure during sintering (kgf/cm²) | Dissolution casting Melting Temperature (°C) | Sintering temperature (°C) | Presence or absence of rolling in casting | sintering time in sintering (H) | Theoretical density ratio (%) |
|---|---|---|---|---|---|---|---|---|
| C. Ex. 1 | HP | | 300 | | 750 | | 2 | 97 |
| C. Ex. 2 | Press molding, sintering in hydrogen | 1200 | | | 400 | | 5 | 96 |
| C. Ex. 3 | HP | | 150 | | 370 | | 6 | 96 |
| C. Ex. 4 | HP | | 200 | | 750 | | 2 | 98 |
| C. Ex. 5 | HP | | 350 | | 750 | | 1 | 98 |
| C. Ex. 6 | HP | | 1000 | | 170 | | 1 | 91 |
| C. Ex. 7 | Air-cooling without use of water-cooling mold in casting | | | 1150 | | Absent | | 100 |
| C. Ex. 8 | Air-cooling without use of water-cooling mold in casting | | | 1100 | | Absent | | 100 |
| C. Ex. 9 | Air-cooling without use of water-cooling mold in casting | | | 1200 | | Absent | | 100 |
| C. Ex. 10 | HP | | 300 | | 350 | | 1 | 91 |
| C. Ex. 11 | Air-cooling without use of water-cooling mold in casting | | | 1150 | | Absent | | 100 |
| C. Ex. 12 | HP | | 1000 | | 700 | | 1 | 98 |
| C. Ex. 13 | Air-cooling without use of water-cooling mold in casting | | | 1150 | | | Without rolling | 100 |
| C. Ex. 14 | HP | | 200 | | 750 | | 2 | 98 |
| C. Ex. 15 | HP | | 250 | | 700 | | 1 | 97 |
| C. Ex. 16 | HP | | 350 | | 380 | | 2 | 95 |
| C. Ex. 17 | HP | | 1000 | | 160 | | 1 | 93 |
| C. Ex. 18 | HP | | 350 | | 220 | | 2 | 95 |
| C. Ex. 19 | Air-cooling without use of water-cooling mold in casting | | | 1100 | | Absent | | 100 |
| C. Ex. 20 | Air-cooling without use of water-cooling mold in casting | | | 1100 | | Absent | | 100 |

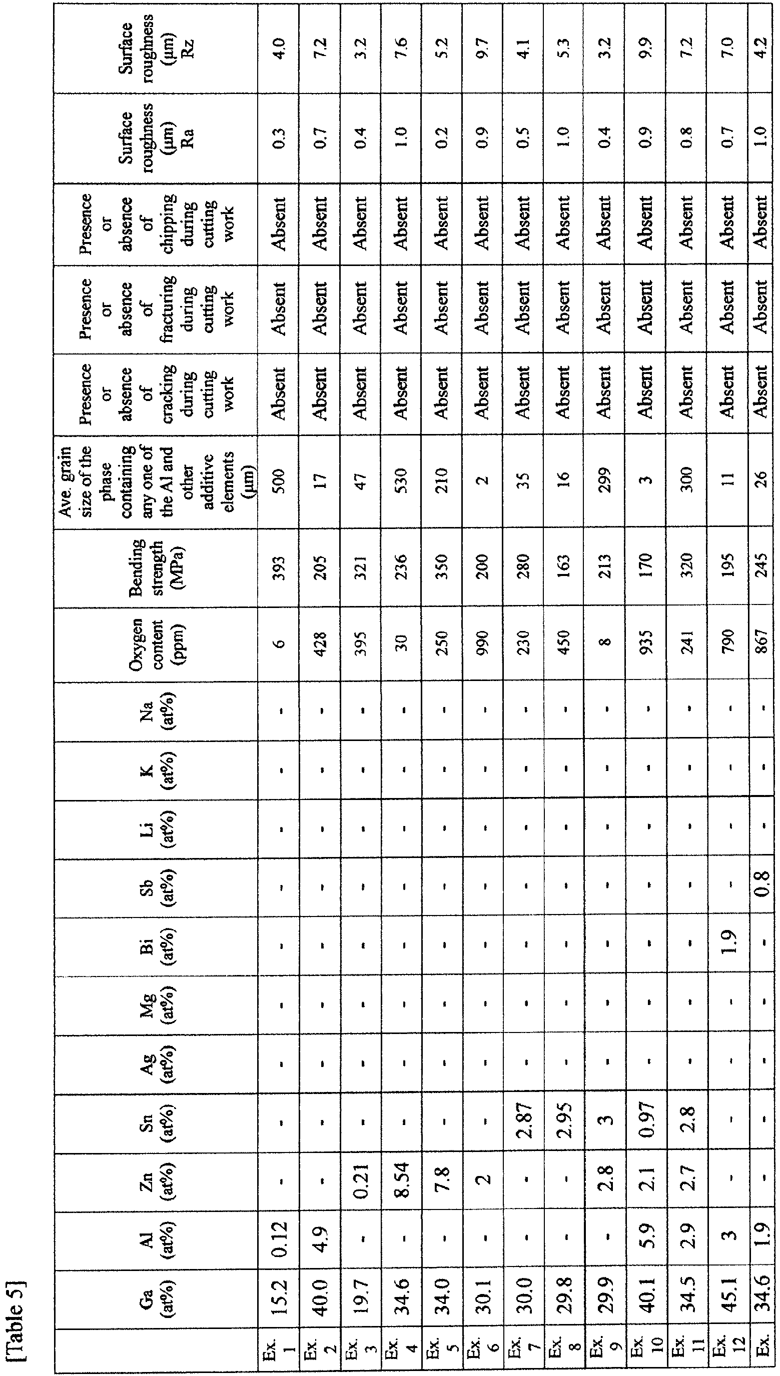

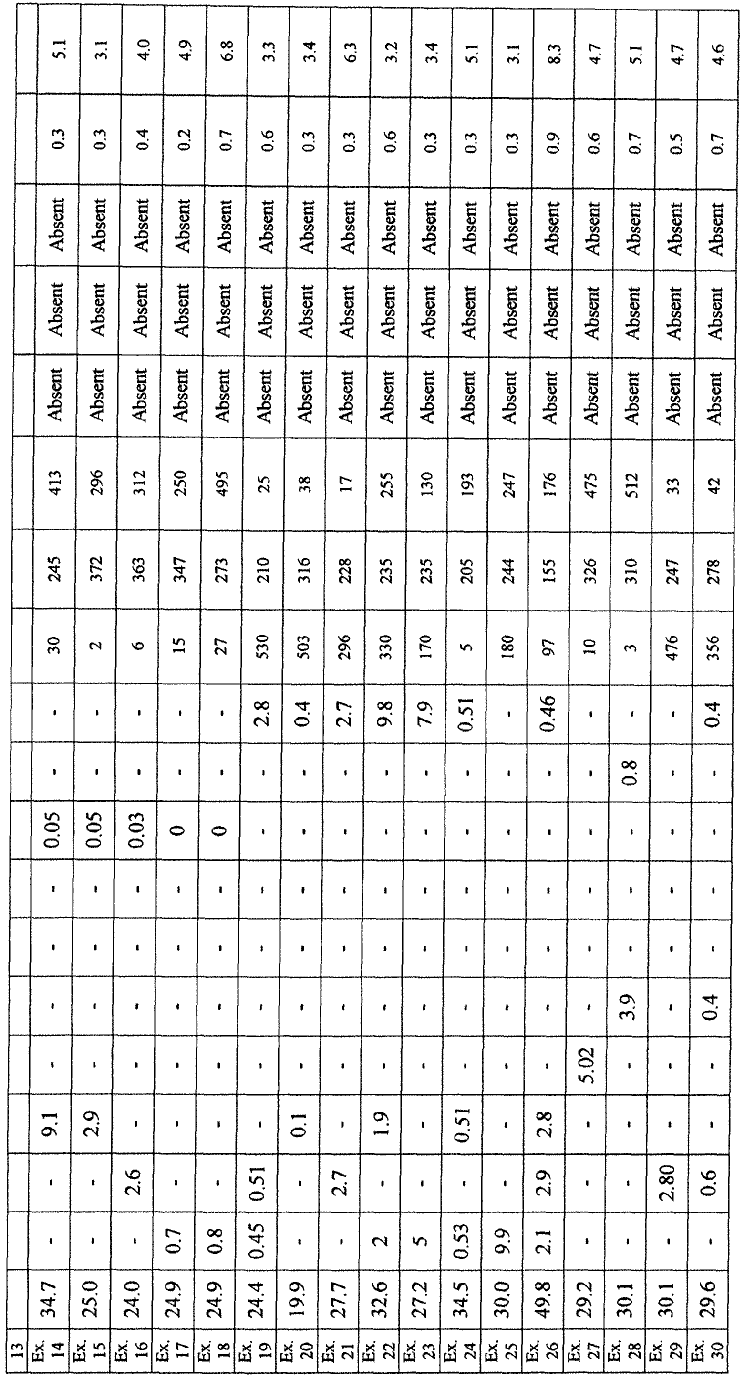

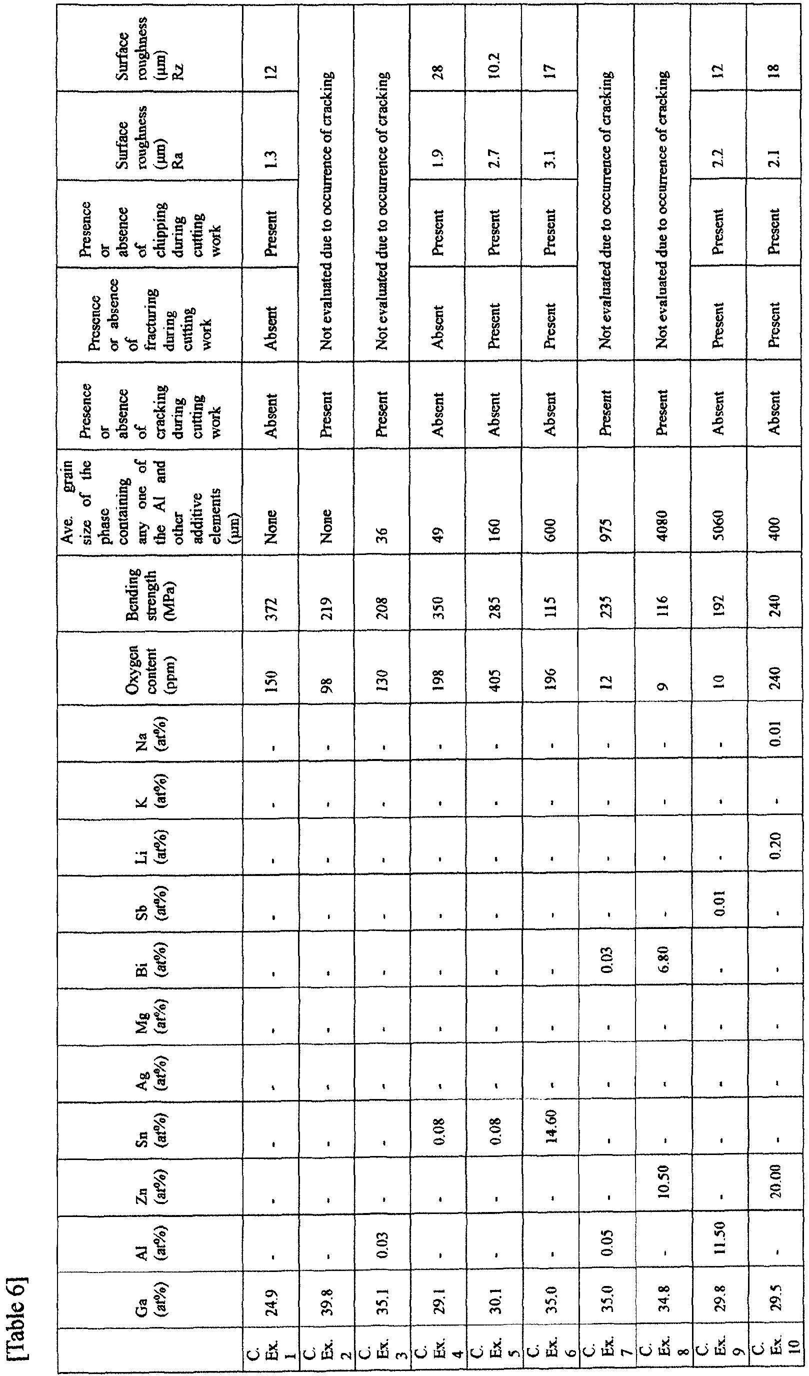

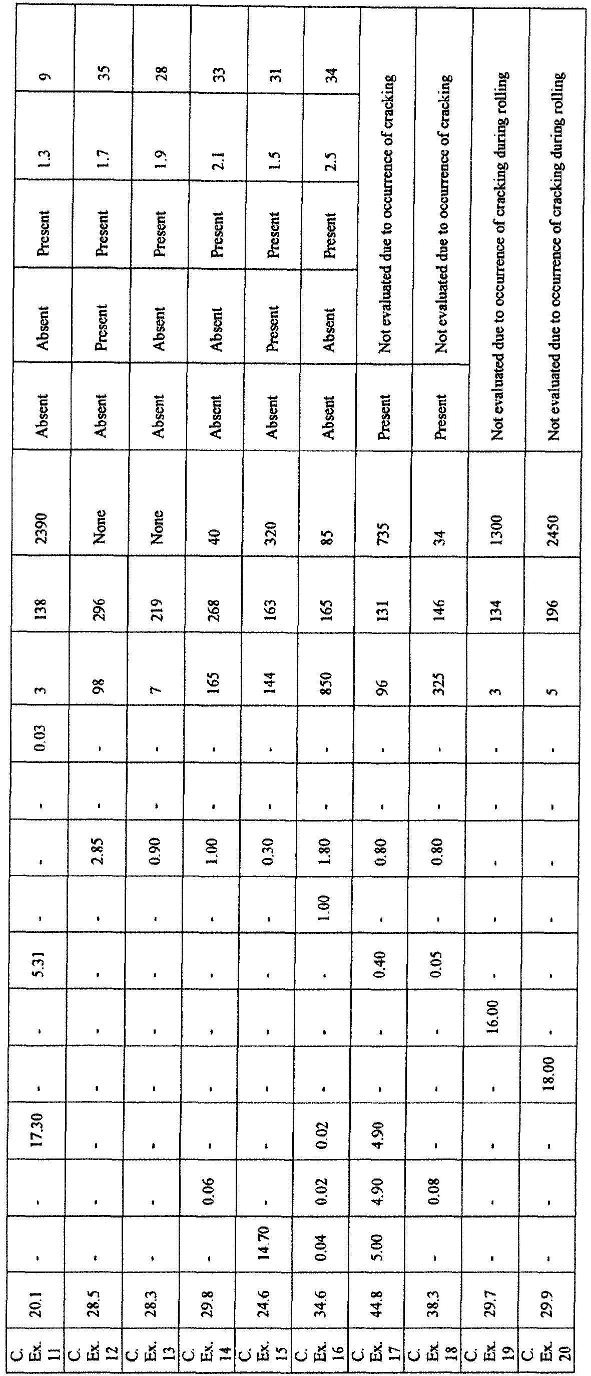

Based on these evaluation results, it was demonstrated that the surface roughness after cutting work was high; and Ra and Rz were 1.0 µm or higher and 10 µm or higher, respectively, in any one of: Comparative Examples 1-5, 7, 12-14, 16, and 18, in which no Al and other additive element was added or the Al and other additive element whose content was lower than the lower limit in the present invention; and Comparative Examples 6, 8-11, 15, and 17, in which the content of the Al and other additive element was higher than the upper limit in the present invention. Contrary to that, there was not chipping during cutting work; the surface roughness was low, and Ra and Rz were 1.0 µm or less and 9.9 µm or less, respectively; and an excellent machinability by cutting was obtained, in any one of Example 1-30 of the present invention, in which the Al and other additive element was added in the effective content amount. Moreover, contrary to the fact that excellent cutting work was done in all of Examples of the present invention, cracking occurred during cutting work, and the material could not be machined into the intended sputtering target, in Comparative Example 2 in which there was no Al and other additive element; Comparative Examples 3, 7, and 18 in which the content of the Al and other additive element was lower than the lower limit in the present invention; and Comparative Examples 8 and 17 in which the content of the Al and other additive element was higher than the upper limit in the present invention. In terms of Comparative Examples 19 and 20, cracking occurred during rolling and they could not be subjected to further evaluation.

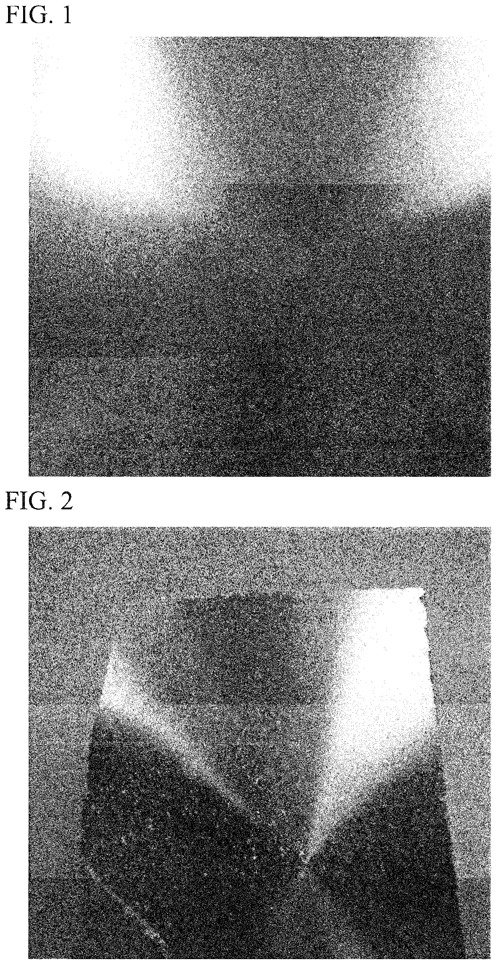

As an example, a photographic image of the surface of the target in Example 23 of the present invention, which was Cu-30%Ga-3%Zn-3%Na-3%F (atomic %), after cutting work is shown in FIG. 1. In addition, a photographic image of the surface of the target in Comparative Example 2, which was Cu-30%Ga-3%Na-3%F (atomic %), after cutting work is shown in FIG. 2.

In terms of the results of the structure observation, as an example, element distribution mapping images by EPMA of the sputtering target of Example 7 of the present invention, which was Cu-30%Ga-3%Sn (atomic %), are shown in FIG. 3. Originally, the EPMA images were colored images, and they were converted to grey-scaled images. In these converted images, the higher the brightness, the higher the content.

While preferred embodiments and Examples of the invention have been described and illustrated above, it should be understood that these are exemplary of the invention and are not to be considered as limiting. Additions, omissions, substitutions, and other modifications can be made without departing from the scope of the present invention. Accordingly, the invention is not to be considered as being limited by the foregoing description, and is only limited by the scope of the appended claims.

### INDUSTRIAL APPLICABILITY

A sputtering target made of a Cu-Ga alloy can be produced more efficiently. Further to the subject matter defined in the claims, the present invention also relates to the following aspects:

### Embodiment 1:

A sputtering target comprising: with respect to an all of metal elements in the sputtering target, 15.0 to 50.0 atomic% of Ga; 0.1 to 10.0 total atomic% of one or more metal elements selected from Zn, Sn, Ag, and Mg; and the Cu balance and inevitable impurities.

### Embodiment 2:

The sputtering target according to Embodiment 1, wherein a theoretical density ratio is 95% or more, and an oxygen content is 800 weight ppm or less.

### Embodiment 3:

The sputtering target according to Embodiment 1 or 2, wherein a bending strength is 200 MPa or more.

### Embodiment 4:

The sputtering target according to any one of Embodiments 1 to 3, wherein an average grain size of a metallic phase including one or more metal elements selected from Zn, Sn, Ag, and Mg, is 500 µm or less.

### Embodiment 5:

The sputtering target according to any one of Embodiments 1 to 4, further comprising, with respect to an all of metal elements in the sputtering target, 0.01 to 10.0 total atomic% of one or more elements selected from Li, K, and Na.

### Embodiment 6:

A production method of the sputtering target according to any one of Embodiments 1 to 4, the method comprising the step of producing an ingot by melting Cu and Ga; and one or more metal elements selected from Zn, Sn, Ag, and Mg at 1050°C or higher to obtain a melted material, and by casting the melted material.

### Embodiment 7:

A production method of the sputtering target according to any one of Embodiments 1 to 4, the method comprising the steps of:
preparing a raw material powder comprising: Cu; Ga; and one or more metal elements selected from Zn, Sn, Ag, and Mg, each of which is included as an elemental powder or an alloy powder including two or more of Cu, Ga, Zn, Sn, Ag, and Mg; and
sintering the raw material powder in a vacuum; in an inert atmosphere; or in a reduction atmosphere.

### Embodiment 8:

A production method of the sputtering target according to Embodiment 5, the method comprising the step of:
preparing a raw material powder by mixing: a metal powder comprising: Cu; Ga; and one or more metal elements selected from Zn, Sn, Ag, and Mg, each of which is included as an elemental powder or an alloy powder including two or more of Cu, Ga, Zn, Sn, Ag, and Mg; and NaF powder, Na₂S powder, or Na₂Se powder; and
sintering the raw material powder in a vacuum; in an inert atmosphere; or in a reduction atmosphere.

### Embodiment 9:

The method of producing the sputtering target according to Embodiment 7 or 8, wherein the average grain size of the raw material powder is 1 to 500 µm.

## Claims

1. A sputtering target comprising: with respect to all of the metal elements in the sputtering target, 15.0 to 50.0 atomic% of Ga; 0.1 to 10.0 total atomic% of one or more metal elements selected from Al, Zn, Sn, Ag, and Mg; and the Cu balance and inevitable impurities,
wherein
a theoretical density ratio is 95% or more, and an oxygen content is 800 weight ppm or less.

2. The sputtering target according to Claim 1, wherein a bending strength is 200 MPa or more.

3. The sputtering target according to Claim 1 or 2, wherein an average grain size of a metallic phase including one or more metal elements selected from Al, Zn, Sn, Ag, and Mg, is 500 µm or less.

4. The sputtering target according to any one of Claims 1 to 3, further comprising, with respect to all of the metal elements in the sputtering target, 0.01 to 10.0 total atomic% of one or more elements selected from Li, K, and Na.

5. A production method of the sputtering target according to any one of Claims 1 to 3, the method comprising the step of producing an ingot by melting Cu and Ga; and one or more metal elements selected from Al, Zn, Sn, Ag, and Mg at 1050°C or higher to obtain a melted material, and by casting the melted material, wherein
a theoretical density ratio is 95% or more, and an oxygen content is 800 weight ppm or less.

6. A production method of the sputtering target according to any one of Claims 1 to 3, the method comprising the steps of:
preparing a raw material powder comprising: Cu; Ga; and one or more metal elements selected from Al, Zn, Sn, Ag, and Mg, each of which is included as an elemental powder or an alloy powder including two or more of Cu, Ga, and Al; and
sintering the raw material powder in a vacuum; in an inert atmosphere; or in a reduction atmosphere, wherein
a theoretical density ratio is 95% or more, and an oxygen content is 800 weight ppm or less.

7. A production method of the sputtering target according to Claim 4, the method comprising the step of:
preparing a raw material powder by mixing: a metal powder comprising: Cu; Ga; and one or more metal elements selected from Al, Zn, Sn, Ag, and Mg, each of which is included as an elemental powder or an alloy powder including two or more of Cu, Ga, Al, Zn, Sn, Ag, and Mg; and NaF powder, Na₂S powder, or Na₂Se powder; and
sintering the raw material powder in a vacuum; in an inert atmosphere; or in a reduction atmosphere, wherein
a theoretical density ratio is 95% or more, and an oxygen content is 800 weight ppm or less.

8. The method of producing the sputtering target according to Claim 6 or 7, wherein the average grain size of the raw material powder is 1 to 500 µm.
